# EUROPEAN PATENT APPLICATION

(11) **EP 1 605 587 A1**
(43) Date of publication of application: **14.12.2005**
(21) Application number: 04013390.2
(22) Date of filing: 07.06.2004
(51) Int. Cl.: H03G 3/30, H04B 1/10

(54) **A receiver comprised in a radio communication system**

(71) Applicant: Infineon Technologies AG, 81669 München (DE)
(72) Inventor: Rudberg, Mikael, 583 32 Linköping (SE)
(74) Representative: Epping - Hermann - Fischer

(57) **Abstract**

The present invention relates to a receiver (100) comprised in a radio communication system, which receiver (100) is operable to optimise the use of the available dynamic range. The receiver (100) comprises an automatic gain control means (102) comprised in an automatic gain control loop. The receiver (100) also comprises a first measurement means (104) connected to said automatic gain control means (102) operable to measure the total received energy. The receiver (100) also comprises a second measurement means (106) connected to said automatic gain control means (102) operable to measure the inband signal energy. The automatic gain control means (102) is operable to adjust the gain in dependence of both the total received energy and the inband signal energy.

## Description

### Field of invention

The present invention relates in a first aspect to a receiver comprised in a radio communication system.

According to a second aspect the present invention relates to a method for optimising the use of the available dynamic range in a receiver comprised in a radio communication system.

According to a third aspect the present invention relates to at least one computer program product for optimising the use of the available dynamic range in a receiver comprised in a radio communication system.

### Background of the invention

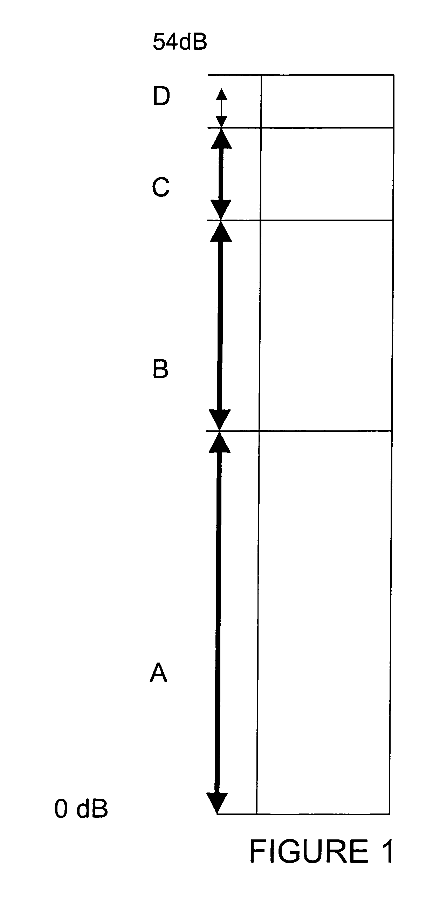

Wireless LAN systems have the drawback of having to operate with a strong adjacent channel energy. Due to the channel spacing it is difficult to remove all adjacent channel energy using analogue filters, causing a substantial amount of energy being present at the input of the A/D converters in a WLAN receiver in the worst case. To cope with this the A/D converters are usually run at a higher conversion rate than needed for the inband signal only. Usually 2 - 4 times oversampling is used in order to being able to use digital filtering to remove the 1^{st} and possibly the second adjacent channel. A typical budget for a WLAN system A/D converters is shown in Figure 1.

In Figure 1 there is disclosed a typical WLAN A/D converter dynamic range budget, wherein A represents the range required for signal energy, B represents the adjacent channel energy, C represents the crest factor headroom and D represents the inband noise etc.

When a frame is received a gain control loop (AGC) is running in order to adjust the gain in the receiver to achieve an optimal signal level at the input of the A/D converters. Here there are two possibilities:
- The received signal contains adjacent channel interference.
- The received signal do not contain (Or only have minor) adjacent channel inference.

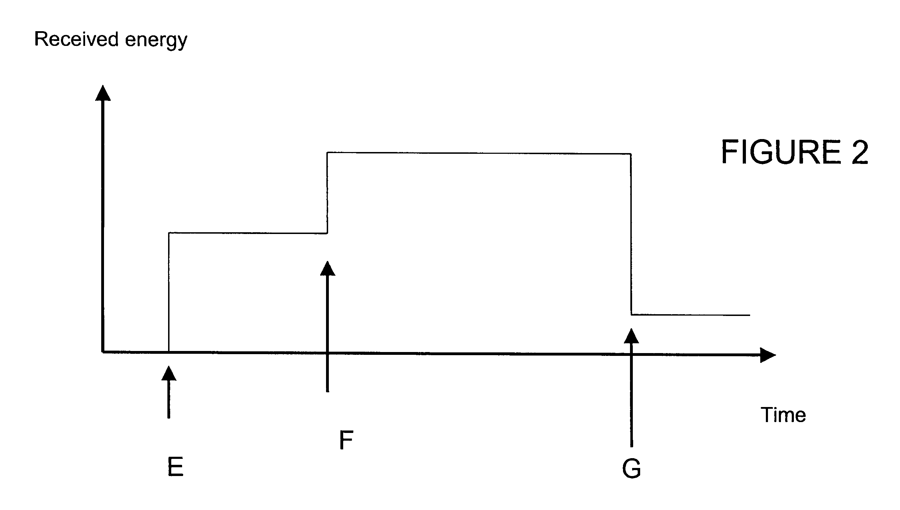

Since a typical AGC loop measures the received signal energy and sets the gain for maximum utilization of the available dynamic range there will be a problem if the adjacent channel interference increase after the AGC loop is finished but before the entire frame is received. If this situation occurs the signal will start to clip, producing inband noise seriously reducing the performance, see Figure 2.

In Figure 2 there is disclosed the adjacent interference starting after AGC freeze, wherein E represents the start of the frame, F represents the adjacent channel transmission start causing severe clipping noise, and G represents the end of the frame.

In Figure 3 there is disclosed the A/D converter dynamic range budget, wherein the clip level is 54 dB, meaning that B, the adjacent channel energy will overload the A/D converter which will cause clipping. The reference signs used in Figure 3 corresponds to the reference signs used in Figure 1.

### Summary of the invention

The object with the present invention is to solve the above mentioned problems. This is achieved with a receiver according to Claim 1. The receiver according to the present invention is comprised in a radio communication system. The receiver is operable to optimise the use of the available dynamic range. The receiver comprises an automatic gain control means comprised in an automatic gain control loop. The receiver also comprises a to said automatic gain control means connected first measurement means operable to measure the total received energy. The receiver also comprises a to said automatic gain control means connected second measurement means operable to measure the inband signal energy, wherein said automatic gain control means is operable to adjust the gain in dependence of both the total received energy and the inband signal energy.

An advantage with the receiver according to the present invention is that it is possible to use the available dynamic range in a more optimal way.

Another advantage is a substantial improvement of radio communication systems with many adjacent interferers, as for instance airports.

A further advantage in this connection is achieved if said receiver also comprises a to said automatic gain control means connected radio frequency means comprised in said automatic gain control loop, wherein said radio frequency means receives said adjusted gain from said automatic gain control means.

In this connection, a further advantage is achieved if said receiver also comprises at least one A/D converter means connected to said radio frequency means and to said first measurement means, and a filter means connected to said A/D converter means and to said second measurement means.

A further advantage in this connection is achieved if said automatic gain control means adjusts the gain in such a way that the inband signal energy (IE) come close to a target inband energy (SE).

In this connection, a further advantage is achieved if said automatic gain control means sets the target inband energy (SE) in accordance with the expression: 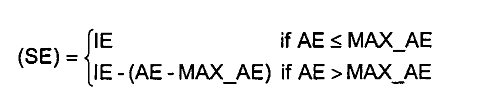 wherein AE = TE - IE is the adjacent energy and TE is the total energy, and MAX_AE is the maximum allowable level of the adjacent energy (AE).
The above mentioned problems are also solved with a method for optimising the use of the available dynamic range in a receiver comprised in a radio communication system according to Claim 6. The method comprises the steps:
- to measure the total received energy;
- to measure the inband signal energy; and
- to adjust the gain in an automatic gain control loop in dependence of both said total received energy and said inband signal energy.
   An advantage with the method according to the present invention is that it is possible to use the available dynamic range in a more optimal way.
   Another advantage is a substantial improvement of radio communication systems with many adjacent interferers, as for instance airports.
   A further advantage in this connection is achieved if said method also comprises the steps:

- to A/D convert the received signal; and
- to filter the A/D converted signal.

In this connection, a further advantage is achieved if said method also comprises the step:
- to adjust the gain in such a way that the inband signal energy (IE) comes close to a target inband energy (SE).

A further advantage in this connection is achieved if said method also comprises the step:
- to set the target inband energy (SE) in accordance with the expression: 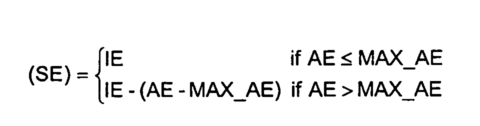
wherein AE = TE - IE is the adjacent energy and TE is the total energy, and MAX_AE is the maximum allowable level of the adjacent energy (AE).
The above mentioned problems are also solved with at least one computer program product according to Claim 10. The at least one computer program product is/are directly loadable into the internal memory of at least one digital computer, comprising software code portions for performing the steps of Claim 6 when said at least one product is/are run on said at least one computer.
An advantage with said at least one computer program product is/are that it is possible to use the available dynamic range in a more optimal way.
Another advantage is a substantial improvement of WLAN networks with many adjacent interferers, as for instance airports.
The present invention will in the following by way of embodiments be described in more detail, in conjunction with the enclosed drawings, in which:

### Brief description of the drawings

Figure 1 shows a typical dynamic range budget for a WLAN system A/D converters;
Figure 2 shows a diagram of adjacent interference starting after AGC freeze;

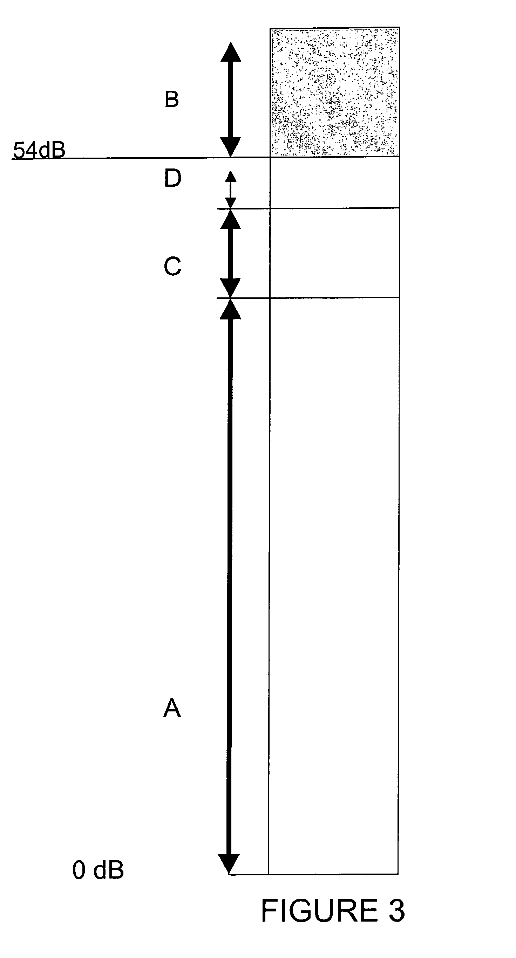

Figure 3 shows a typical dynamic range budget for a WLAN system A/D converters with clipping;

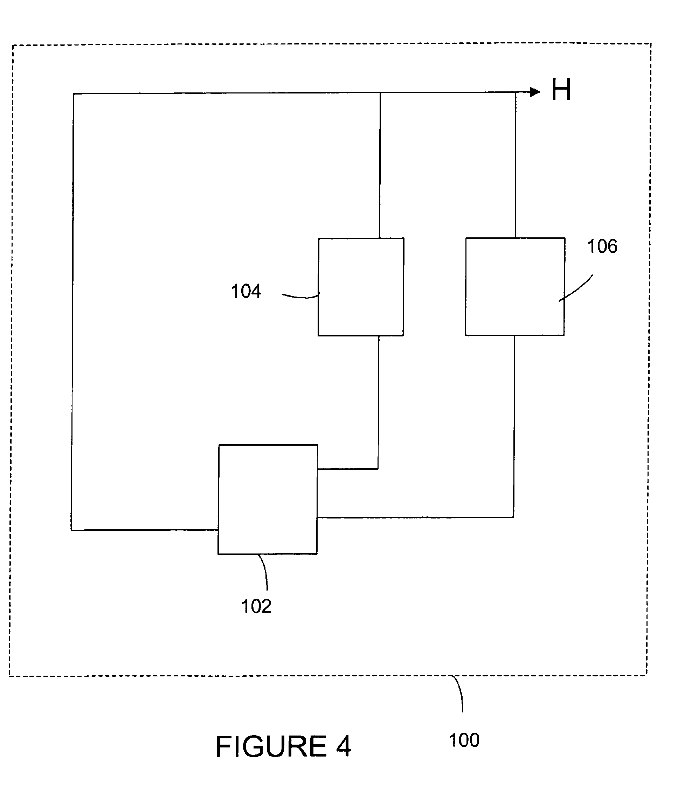

Figure 4 is a block diagram of a receiver according to the present invention;

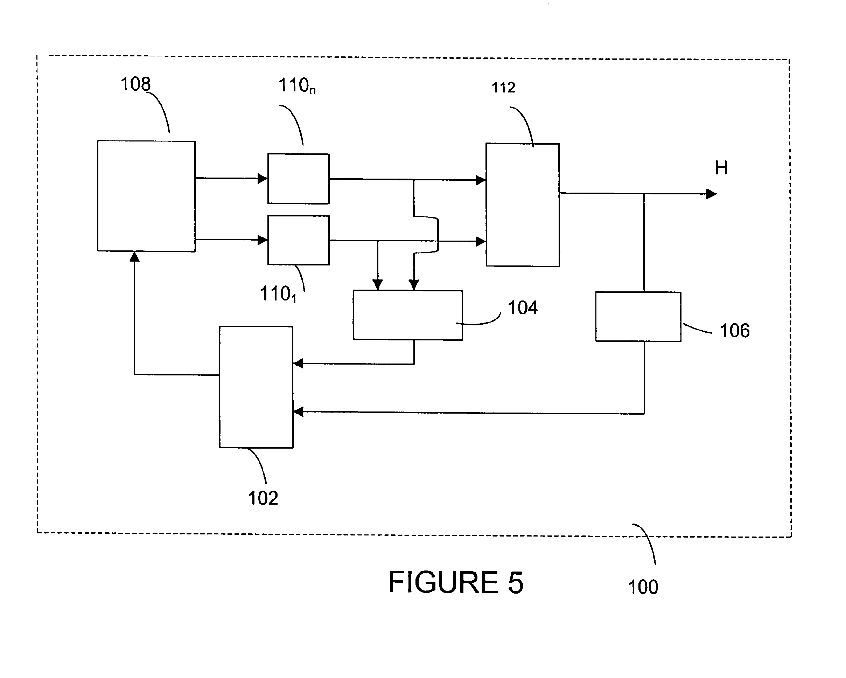

Figure 5 is a more detailed block diagram of the receiver disclosed in Figure 4;

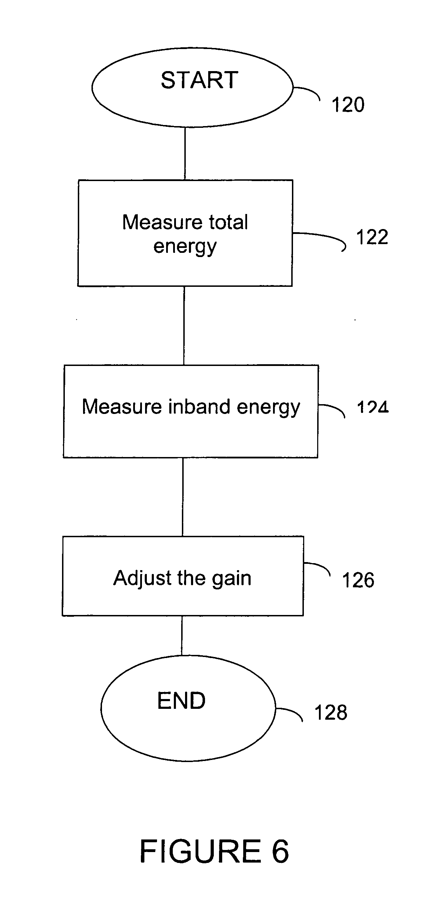

Figure 6 is a flow chart of a method for optimising the use of the available dynamic range in a receiver comprised in a radio communication system according to the present invention;

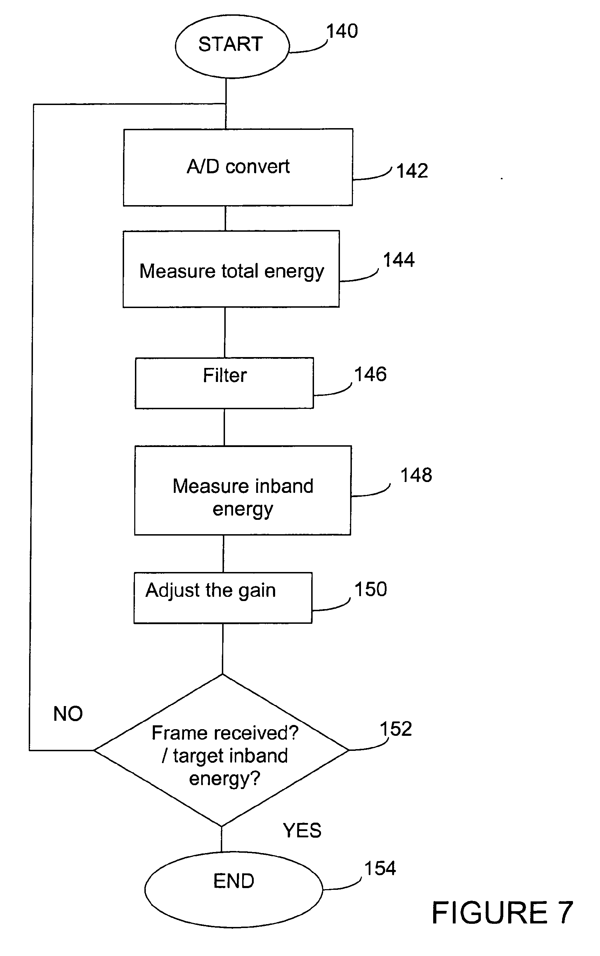

Figure 7 is a more detailed flow chart of the method disclosed in Figure 6; and

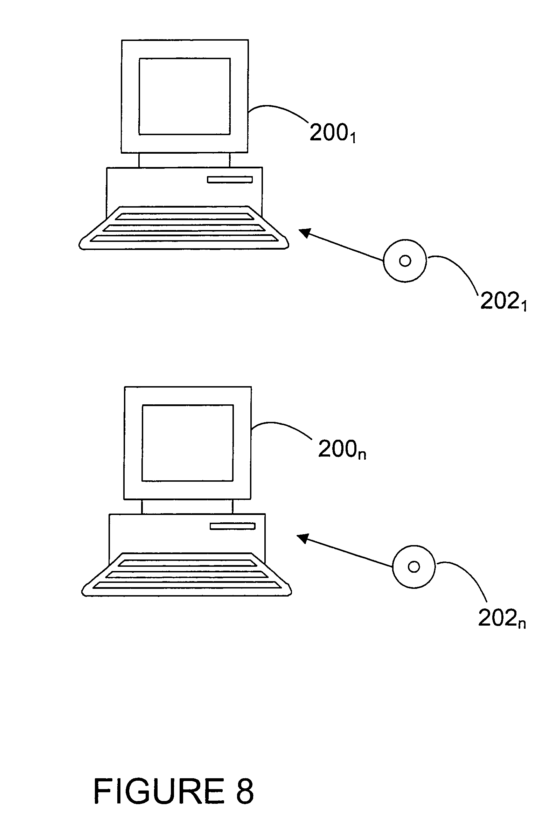

Figure 8 show some examples of computer program products according to the present invention.

### Detailed description of embodiments

In Figure 4 there is disclosed a block diagram of a receiver 100 according to the present invention. The receiver 100 is comprised in a radio communication system. The receiver 100 is operable to optimise the use of the available dynamic range. The receiver 100 comprises an automatic gain control means 102 comprised in an automatic gain control loop. The receiver 100 also comprises a to said automatic gain control means 102 connected first measurement means 104 operable to measure the total received energy. The receiver 100 also comprises a second measurement means 106 connected to said automatic gain control means 102. The second measurement means 106 is operable to measure the inband signal energy. The automatic gain control means 102 is operable to adjust the gain in dependence of both the total received energy and the inband signal energy. The reference sign H represents the output signal of the receiver 100.
The radio communication system mentioned in this description can e.g. be operated in accordance with one of the following radio standards: wireless LAN, i.e. IEEE802.11a/b/g, Hiperlan 1 and 2, Bluetooth, GSM/GSM-GPRS, WCDMA and CDMA 2000.
In Figure 5 there is disclosed a more detailed block diagram of the receiver 100 disclosed in Figure 4. Some of the means/functional blocks in Figure 5 corresponds to the same means/functional blocks in Figure 4 and these have been allocated the same reference signs in both Figure 4 and Figure 5 and will not be described again. The receiver 100 disclosed in Figure 5 also comprises a to said automatic gain control means 102 connected radio frequency means 108 comprised in said automatic gain control loop. The radio frequency means 108 receives said adjusted gain from the automatic gain control means 102. The receiver 100 also comprises at least one A/D converter means 110₁,..., 110ₙ connected to the radio frequency means 108. The at least one A/D converter means 110₁,..., 110ₙ is/are also connected to the first measurement means 104. The receiver 100 also comprises a filter means 112 connected to said A/D converter means 110₁,..., 110ₙ and to said second measurement means 106.
In a preferred embodiment of the receiver 100, the automatic gain control means 102 adjusts the gain in such a way that the inband signal energy, IE, come close to a target inband energy, SE.
In a preferred embodiment of the receiver 100, the automatic gain control means 102 sets the target inband energy, SE, in accordance with the expression: 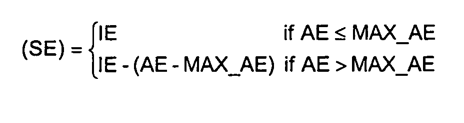 wherein AE = TE - IE is the adjacent energy and TE is the total energy, and MAX_AE is the maximum allowable level of the adjacent energy (AE).

The inventive concept can be expressed with other words

Both total received energy and inband energy estimates are fed to the AGC block. Common solution use only the measured energy from the total energy measurements to set the gain. That is the gain is adjusted until the total energy (TE) reading is the same, or close to some target level GE.

In the proposed solution the gain is instead adjusted so that the inband signal gets enough dynamic range. That is the inband signal energy (IE) shall be close to the optimal signal energy level (SE). With this gain target we can handle a varying adjacent channel interference even after a gain freeze.

Only if the adjacent channel interference is stronger than the maximum allowable level the signal is clipping at the A/D converter. This can be handled by adjusting the gain target slightly. If the adjacent energy (AE = TE - IE) is higher than what can be handled, the gain is reduced by this amount. That is, the new target input energy is:

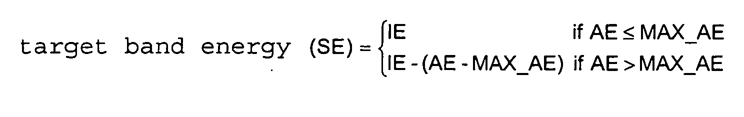

In Figure 6 there is disclosed a flow chart of the method for optimising the use of the available dynamic range in a receiver comprised in a radio communication system. The method begins at block 120. The method continues, at block 122, with the step: to measure the total received energy. Thereafter, the method continues, at block 124, with the step: to measure the inband signal energy. The method continues, at block 126, with the step: to adjust the gain in an automatic gain control loop in dependence of both the total received energy and the inband signal energy. The method is finished at block 128.

In Figure 7 there is disclosed a more detailed flow chart of the method disclosed in Figure 6. The method begins at block 140. The method continues, at block 142, with the step: to A/D convert the received signal. This step can be performed in one single step, or be divided into several A/D conversion steps performed in parallel. See Figure 5. Thereafter, the method continues, at block 144, with the step: to measure the total received energy. The method continues, at block 146, with the step: to filter the A/D converted signal. Thereafter, the method continues, at block 148, with the step: to measure the inband signal energy. The method continues, at block 150, with the step: to adjust the gain in an automatic gain control loop in dependence of both said total received energy and said inband signal energy. Thereafter the method continues, at block 152, with the question: is the entire frame received? If the answer is negative the method continues by performing the step according to block 142 again. If, on the other hand, the answer is affirmative, the method continues, at block 154, with the step: to finish the method.

According to another embodiment, the method continues at block 152, with the question: is IE sufficiently close to the target inband energy (SE)? If the answer is negative the method continues by performing the step according to block 142 again. If, on the other hand, the answer is affirmative, the method continues, at block 154, with the step: to finish the method.

According to another embodiment, the method continues, at block 152, with the question: is the current time ≥ a time threshold? If the answer is negative, the method continues by performing the step according to block 142 again. If, on the other hand, the answer is affirmative, the method continues, at block 154, with the step: to finish the method. This solution implies that the gain will be locked within a certain time limit, the time threshold.

In a preferred embodiment, said method also comprises the step: to adjust the gain in such a way that the inband signal energy (IE) comes close to a target inband energy (SE).

In a preferred embodiment, said method also comprises the step: 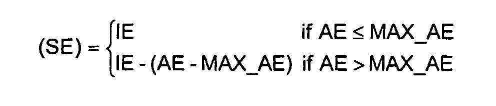 wherein AE = TE - IE is the adjacent energy and TE is the total energy, and MAX_AE is the maximum allowable level of the adjacent energy (AE). In Figure 8 there is disclosed a schematic diagram of some computer program products according to the present invention. There is disclosed n different digital computers 200₁, ..., 200ₙ, wherein n is an integer. There is also disclosed n different computer program products 202₁, ..., 202ₙ, here showed in the form of compact discs. The different computer program products 202₁, ..., 202ₙ are directly loadable into the internal memory of the n different digital computers 200₁, ..., 200ₙ. Each computer program product 202₁, ..., 202ₙ comprises software code portions for performing some or all the steps of Figure 6 when the product (s) 202₁ ..., 202ₙ is/are run on said computer (s) 200₁ ..., 200ₙ. Said computer program products 202₁, ..., 202ₙ can e. g. be in the form of floppy disks, RAM disks, magnetic tapes, opto magnetical disks or any other suitable products.
The invention is not limited to the embodiments described in the foregoing. It will be obvious that many different modifications are possible within the scope of the following claims.

## Claims

1. A receiver (100) comprised in a radio communication system, which receiver (100) is operable to optimize the use of the available dynamic range, wherein said receiver (100) comprises an automatic gain control means (102) comprised in an automatic gain control loop, **characterized in that** said receiver (100) also comprises a to said automatic gain control means (102) connected first measurement means (104) operable to measure the total received energy, and a to said automatic gain control means (102) connected second measurement means (106) operable to measure the inband signal energy, wherein said automatic gain control means (102) is operable to adjust the gain in dependence of both the total received energy and the inband signal energy.

2. A receiver (100) according to Claim 1, **characterized in that** said receiver (100) also comprises a to said automatic gain control means (102) connected radio frequency means (108) comprised in said automatic gain control loop, wherein said radio frequency means (108) receives said adjusted gain from said automatic gain control means (102).

3. A receiver (100) according to Claim 2, **characterized in that** said receiver (100) also comprises at least one A/D converter means (110₁,..., 110ₙ) connected to said radio frequency means (108) and to said first measurement means (104), and a filter means (112) connected to said A/D converter means (110₁,...,110ₙ) and to said second measurement means (106).

4. A receiver (100) according to anyone of Claims 1-3, **characterized in that** said automatic gain control means (102) adjusts the gain in such a way that the inband signal energy (IE) come close to a target inband energy (SE).

5. A receiver (100 according to Claim 4, **characterized in that** said automatic gain control means (102) sets the target inband energy (SE) in accordance with the expression: 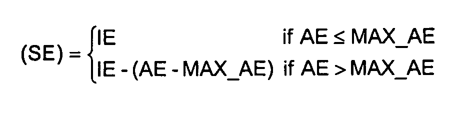 wherein AE = TE - IE is the adjacent energy and TE is the total energy, and MAX_AE is the maximum allowable level of the adjacent energy (AE).

6. A method for optimising the use of the available dynamic range in a receiver comprised in a radio communication system, wherein said method comprises the steps:
- to measure the total received energy;
- to measure the inband signal energy; and
- to adjust the gain in an automatic gain control loop in dependence of both said total received energy and said inband signal energy.

7. A method for optimising the use of the available dynamic range in a receiver comprised in a radio communication system according to Claim 6, **characterized in that** said method also comprises the steps:
- to A/D convert the received signal; and
- to filter the A/D converted signal.

8. A method for optimising the use of the available dynamic range in a receiver comprised in a radio communication system according to Claim 6 or 7, **characterized in that** said method also comprises the step:
- to adjust the gain in such a way that the inband signal energy (IE) comes close to a target inband energy (SE).

9. A method for optimising the use of the available dynamic range in a receiver comprised in a radio communication system according to Claim 8, **characterized in that** said method also comprises the step:
- to set the target inband energy (SE) in accordance with the expression: 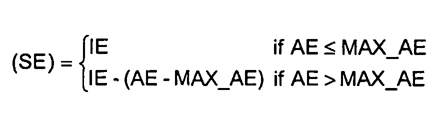
wherein AE = TE - IE is the adjacent energy and TE is the total energy, and MAX_AE is the maximum allowable level of the adjacent energy (AE).

10. At least one computer program product (202₁, ..., 202ₙ) directly loadable into the internal memory of at least one digital computer (200₁, ..., 200ₙ) , comprising software code portions for performing the steps of Claim 6 when said at least one product (202₁, ..., 202ₙ) is/are run on said at least one computer (200₁, ..., 200ₙ) .
